# EUROPEAN PATENT APPLICATION

(11) **EP 4 712 130 A1**
(43) Date of publication of application: **18.03.2026**
(21) Application number: 24874466.6
(22) Date of filing: 17.09.2024
(51) Int. Cl.: H01L 21/683, C23C 14/08, C23C 14/50, H01L 21/31, H01L 21/3065

(54) **ELECTROSTATIC CHUCK DEVICE, MANUFACTURING METHOD THEREFOR, AND METHOD OF REFURBISHING ELECTROSTATIC CHUCK DEVICE**

(30) Priority: 05.10.2023 JP 2023173583
(71) Applicant: Creative Technology Corporation, Kawasaki-shi, Kanagawa 213-0034 (JP)
(72) Inventor: TATSUMI, Yoshiaki, Kawasaki-shi, Kanagawa 213-0034 (JP); NOBE, Yoshifumi, Kawasaki-shi, Kanagawa 213-0034 (JP); YAMAMOTO, Shingo, Kawasaki-shi, Kanagawa 213-0034 (JP)
(74) Representative: Kraus & Lederer PartGmbB
(86) International application number: PCT/JP2024/033147
(87) International publication number: WO 2025/074857

(57) **Abstract**

Provided is an electrostatic chuck device that can repeatedly exhibit initial performance such as a leakage current value, a volume resistivity, and surface roughness while reducing generation of labor and cost as much as possible with considering a refurbishment treatment after use. The electrostatic chuck device includes: a base substrate having a coolant flow path; and an electrostatic chuck having an internal electrode between an insulating layer and a dielectric layer, wherein a side of the dielectric layer serves as a workpiece attraction surface, wherein the dielectric layer of the electrostatic chuck has an alumina coating film composed of Al₂O₃ having a thickness of 1 µm or more and 5 µm or less on a surface thereof, and the workpiece attraction surface has a volume resistivity at room temperature of 1×10¹⁵ Ω·cm or more.

## Description

### Technical Field

The present invention relates to an electrostatic chuck device having a base substrate and an electrostatic chuck, a manufacturing method therefor, and a method of refurbishing an electrostatic chuck device, and specifically relates to an electrostatic chuck device having a predetermined alumina coating film on a surface of a dielectric layer in an electrostatic chuck, a manufacturing method therefor, and a method of refurbishing an electrostatic chuck device.

### Background Art

In semiconductor manufacturing processes and manufacturing processes of liquid crystal devices that use a plasma etching device, a plasma film-forming device (CVD or PVD), an ion-injecting device, an electron-beam lithography device, etc., electrostatic chuck devices are widely used as a tool for attracting and holding each workpiece.

However, when used in the plasma etching device, for example, the electrostatic chuck device may be damaged by electrochemical actions from ions, electrons, and radicals contained in the plasma.

Specifically, an oxide coating (an alumite coating) of a base substrate constituting the electrostatic chuck device may be, for example, reduced or fluorinated (modified), leading to generation of reaction byproducts, or a dielectric layer of the electrostatic chuck may be deteriorated, leading to increased leakage current. If the electrostatic chuck is continuously used as it is, the reaction byproducts may turn into particles and cause contamination of workpieces such as a semiconductor wafer and a glass substrate, or the increase in the leakage current may lead to decrease in the attraction force relative to these workpieces and damage to circuits formed on the semiconductor wafer.

Thus, the electrostatic chuck device that has been used to some extent is subjected to cleaning of course, and if the damage is large, the surface may be subjected to polishing (polished) to form an oxide coating again (see Patent Literature 1, for example).

However, there is a limit to the device that can be refurbished as the electrostatic chuck device considering labor, cost, etc., and it becomes unavoidable to give up refurbishing the electrostatic chuck device in some cases even when portions other than the damaged portion are normal.

To achieve plasma resistance during the plasma etching, disclosed is providing a coating layer with 20 µm or less by electron-beam coating assisted by ion beam (see Patent Literature 2). Patent Literature 2 describes examples, etc. of coating with yttria (Y₂O₃) having a thickness of 5 µm in a state of preheating to 200°C over 1 hour in Examples.

In addition, to achieve corrosion resistance against the plasma, disclosed is providing, in a wafer support in which machinable ceramics include a conductive member, a plasma-protective film on the machinable ceramics (see Patent Literature 3). Patent Literature 3 describes examples of providing the plasma-protective film composed of Y₂O₃ having a thickness of 20 µm, Al₂O₃ having a thickness of 10 µm, etc. by a reactive sputtering method in Examples.

### Citation List

### Patent Literature

Patent Literature 1: JP2005-191500 A
Patent Literature 2: JP2013-512573 A
Patent Literature 3: JP2023-23820 A

### Summary of Invention

### Technical Problem

It is difficult to refurbish the electrostatic chuck device damaged by use in the plasma etching device, etc. so as to satisfy physical property values such as a leakage current value and a volume resistivity with reduced labor and cost, and there is a limit to actually reusing the device as the electrostatic chuck device.

Accordingly, the present inventors have made intensive investigation to achieve the electrostatic chuck device designed with consideration for a refurbishment treatment after use, and consequently found that the electrostatic chuck device as above can be achieved by setting the dielectric layer of the electrostatic chuck to have an alumina coating film having a predetermined film thickness on its surface. This finding has led to completion of the present invention.

Therefore, an object of the present invention is to provide an electrostatic chuck device that can repeatedly exhibit initial performance such as the leakage current value, the volume resistivity, and surface roughness while reducing generation of labor and cost as much as possible with considering a refurbishment treatment after use.

In addition, another object of the present invention is to provide a method for manufacturing an electrostatic chuck device that can be reliably used over a long term while minimizing damage during manufacturing and that can repeat the refurbishment treatments as much as possible.

Further, another object of the present invention is to provide a method of refurbishing an electrostatic chuck device that enables reliably repeated use.

### Solution to Problem

Specifically, the present invention is an electrostatic chuck device comprising: a base substrate having a coolant flow path; and an electrostatic chuck having an internal electrode between an insulating layer and a dielectric layer, wherein a side of the dielectric layer serves as a workpiece attraction surface, wherein the dielectric layer of the electrostatic chuck has an alumina coating film composed of Al₂O₃ having a thickness of 1 µm or more and 5 µm or less on a surface thereof, and the workpiece attraction surface has a volume resistivity at room temperature of 1×10¹⁵ Ω·cm or more.

In addition, the present invention is a method for manufacturing an electrostatic chuck device comprising an electrostatic chuck on a base substrate having a coolant flow path, the method comprising: providing an insulating layer, an internal electrode, and a dielectric layer on the base substrate to form a laminate structure; and subsequently forming an alumina coating film composed of Al₂O₃ having a thickness of 1 µm or more and 5 µm or less on a surface of the dielectric layer at a film-forming temperature of 100°C or less by ion-assisted deposition to provide a workpiece attraction surface having a volume resistivity of 1×10¹⁵ Ω·cm or more on a side of the dielectric layer, thereby forming the electrostatic chuck on the base substrate.

Further, the present invention is a method of refurbishing a used electrostatic chuck device comprising a base substrate having a coolant flow path, and an electrostatic chuck having an internal electrode between an insulating layer and a dielectric layer, wherein a side of the dielectric layer serves as a workpiece attraction surface, the method comprising: forming an alumina coating film composed of Al₂O₃ having a thickness of 1 µm or more and 5 µm or less on a surface of the dielectric layer of the used electrostatic chuck at a film-forming temperature of 100°C or less by ion-assisted deposition to provide a refurbished workpiece attraction surface having a volume resistivity of 1×10¹⁵ Ω·cm or more on the side of the dielectric layer.

The electrostatic chuck device of the present invention has: an electrostatic chuck having an internal electrode between an insulating layer and a dielectric layer, wherein a side of the dielectric layer serves as a workpiece attraction surface; and a base substrate having a coolant flow path.

Among these, the dielectric layer of the electrostatic chuck has an alumina coating film composed of Al₂O₃ having a thickness of 1 µm or more and 5 µm or less on a surface thereof. The alumina coating film is preferably composed of Al₂O₃ having a thickness of 3 µm or more and 5 µm or less. If the film thickness of the alumina coating film is less than 1 µm, the alumina coating film cannot sufficiently play a role of the protective film against plasma while exposure in, for example, a plasma etching device, etc. when the electrostatic chuck device is used over a certain period. In contrast, if the film thickness of the alumina coating film is more than 5 µm, damage caused during formation of the alumina coating film may rather deteriorate performance of the electrostatic chuck device.

As described later, the alumina coating film provided on the surface of the dielectric layer of the present invention is preferably formed by ion-assisted deposition from the viewpoints of preventing impurity contamination, forming a dense film, etc. This ion-assisted deposition typically radiates ionized gas particles with an ion gun during deposition to press the deposition material molecules against the film formation target, which can yield good film quality while flipping the impurity compared with common vacuum deposition, and can form a dense film. That is, a kinetic energy of the material molecules is high in a case of the ion-assisted deposition compared with vacuum deposition, etc. Thus, the present invention focuses on this point to reduce the film thickness of the alumina coating film to 5 µm or less.

As described in Examples, if the film thickness of the alumina coating film is more than 5 µm, temperature during the film formation becomes 100°C or more. Thus, with the electrostatic chuck device in which the base substrate and the electrostatic chuck are bonded via a silicone-based adhesive, for example, such a temperature during the film formation may cause peeling of a part of the silicone-based adhesive on an interface between the base substrate and the electrostatic chuck. In addition, when the electrostatic chuck device has a ceramic thermal sprayed film so as to cover an end surface of a bonding portion where the base substrate and the electrostatic chuck are bonded, film formation of the alumina coating film having a film thickness of more than 5 µm may cause cracks on this ceramic thermal sprayed film.

In the present invention, the alumina coating film composed of Al₂O₃ is contained as a protective film in the electrostatic chuck. Since the alumina coating film composed of Al₂O₃ has a high volume resistivity compared with another film having plasma resistance such as Y₂O₃, the electrostatic chuck device having excellent reliability can be obtained while minimizing the damage during the film formation by limiting the film thickness as mentioned above.

Generally, when attraction principles based on the electrostatic chuck are roughly classified into three: i) a principle based on a Coulomb force; ii) a principle based on a Johnson-Rahbeck force; and iii) a principle based on a gradient force, the electrostatic chuck device according to the present invention is suitable for iii) the principle based on a gradient force. That is, the present invention is suitable as the electrostatic chuck device that exhibits excellent attraction force also against an insulative workpiece specifically hardly causing polarization. Therefore, the workpiece attraction surface has a volume resistivity of 1×10¹⁵ Ω·cm or more. The volume resistivity of the workpiece attraction surface is set by workpiece attraction in a state where the use voltage is applied (voltage-on) and by workpiece removal in a state where the use voltage is released (voltage-off). In addition, there is a limit by the leakage current value of the workpiece attraction surface during attraction. The volume resistivity of the workpiece attraction surface is ideally about 1×10¹⁶ Q·cm, and this value is the substantial upper limit of the volume resistivity. Note that the volume resistivity described in the present invention refers to a value at room temperature (25°C).

The electrostatic chuck device of the present invention favorably has a leakage current value of the workpiece attraction surface of 5×10⁻³ µA or less, and the leakage current value is preferably 1×10⁻³ µA or less. The leakage current value of the workpiece attraction surface of 5×10⁻³ µA or less can inhibit decrease in the attraction force against the workpiece, and even when a semiconductor wafer with formed circuits is attracted as the workpiece, damage to the circuit can be prevented.

In the electrostatic chuck device of the present invention, the electrostatic chuck having the internal electrode between the dielectric layer having the predetermined alumina coating film and the insulating layer is laminated on the base substrate having the coolant flow path, the side of the dielectric layer of the electrostatic chuck serves as the workpiece attraction surface, and this workpiece attraction surface has the aforementioned volume resistivity. The dielectric layer, the insulating layer, and the internal electrode, which constitute the electrostatic chuck, and the base substrate having the coolant flow path may be the same as each of known members. Note that the electrostatic chuck device may be provided with a heater electrode in addition thereto, a thermal sprayed film having plasma resistance may be provided on a side-wall flange surface to be formed on the side wall, etc.

Here, as for the base substrate and the electrostatic chuck, the electrostatic chuck may be bonded to the base substrate by using adhesives, adhesive sheets, etc. The insulating layer, the internal electrode, and the dielectric layer may be sequentially formed by thermally spraying a ceramic thermal sprayed film or a metal thermal sprayed film onto the surface of the base substrate, etc. Alternatively, the insulating layer or the dielectric layer in the electrostatic chuck may be formed with sintered ceramic, and these may be laminated and calcined in a green-sheet state, or may be integrated by hot-press calcination. In this case, the internal electrode may be formed by processing a metal having a high melting point, such as W and Mo, or by printing a metal paste, or formed from metal foil, mesh, etc. to bond the obtained laminated member onto the base substrate by using an adhesive, an adhesive sheet, etc.

For purposes of controlling the workpiece temperature, etc., the base substrate has the coolant flow path for supplying a cooling gas such as helium (He) to the workpiece held on the workpiece attraction surface via the electrostatic chuck, or alternatively, for flowing cooling water for cooling the electrostatic chuck. The material to form this base substrate is not particularly limited, and typical examples thereof include a metallic workpiece substrate composed of aluminum, an aluminum alloy, etc.

For forming the alumina coating film on the surface of the dielectric layer of the electrostatic chuck, as mentioned above, the film-forming temperature is favorably set to 100°C or less by ion-assisted deposition to form the alumina coating film composed of Al₂O₃ having a thickness of 1 µm or more and 5 µm or less. In this case, the alumina coating film may be formed before the electrostatic chuck is laminated on the base substrate, but the alumina coating film composed of Al₂O₃ having a thickness of 1 µm or more and 5 µm or less is preferably formed on the surface of the dielectric layer by ion-assisted deposition at a film-forming temperature of 100°C or less after the insulating layer, the internal electrode, and the dielectric layer are provided on the base substrate to form a laminate structure.

That is, in the method for manufacturing an electrostatic chuck device of the present invention, the alumina coating film composed of Al₂O₃ having a thickness of 1 µm or more and 5 µm or less can be formed by ion-assisted deposition, which allows minimizing the damage during the film formation. Thus, the predetermined alumina coating film can be formed on the surface of the dielectric layer as above after the insulating layer, the internal electrode, and the dielectric layer are provided on the base substrate via a silicone adhesive to form the laminate structure, for example, or alternatively, the predetermined alumina coating film can be formed on the surface of the dielectric layer after the insulating layer, the internal electrode, and the dielectric layer are provided on the base substrate to form the laminate structure and then a ceramic thermal sprayed film is provided on the side surface of this laminate structure.

In addition, the present invention can refurbish a used electrostatic chuck device that has been already used in a semiconductor manufacturing process, a manufacturing process of a liquid crystal device, etc. represented by a plasma etching device, ion-injecting device, etc.

That is, even with an electrostatic chuck device in which the dielectric layer of the electrostatic chuck is deteriorated by electrochemical actions from ions, electrons, radicals, etc. contained in the plasma and has an increased leakage current, the ion-assisted deposition as described above can minimize the damage during the film formation. Thus, the surface of the dielectric layer of this electrostatic chuck is preferably polished, and then the alumina coating film composed of Al₂O₃ having a thickness of 1 µm or more and 5 µm or less can be formed by the ion-assisted deposition at a film-forming temperature of 100°C or less, to refurbish the electrostatic chuck device.

### Advantageous Effect of Invention

The present invention can achieve the electrostatic chuck device that can exhibit again the initial performance when manufactured while reducing generation of labor and cost as much as possible with considering the refurbishment treatment after use.

In addition, the method of the present invention can yield the electrostatic chuck device that can be reliably used over a long term while minimizing the damage during manufacturing. Furthermore, the method of the present invention can be applied for not only a case where a new electrostatic chuck device is manufactured but also a case where a used electrostatic chuck device is refurbished, which enables semipermanent and repeated refurbishment of the electrostatic chuck device having excellent reliability.

### Brief Description of Drawings

[Figure 1] Figure 1 is a process flowchart to obtain an electrostatic chuck device according to the present invention.
[Figure 2] Figure 2 is a sectional photograph of an electrostatic chuck device obtained in Test Example 1.
[Figure 3] Figure 3 is a sectional photograph of an electrostatic chuck device obtained in Test Example 2.

### Description of Embodiments

Hereinafter, the electrostatic chuck device of the present invention will be specifically described with reference to preferable configuration examples. Note that the present invention is not limited to the following contents.

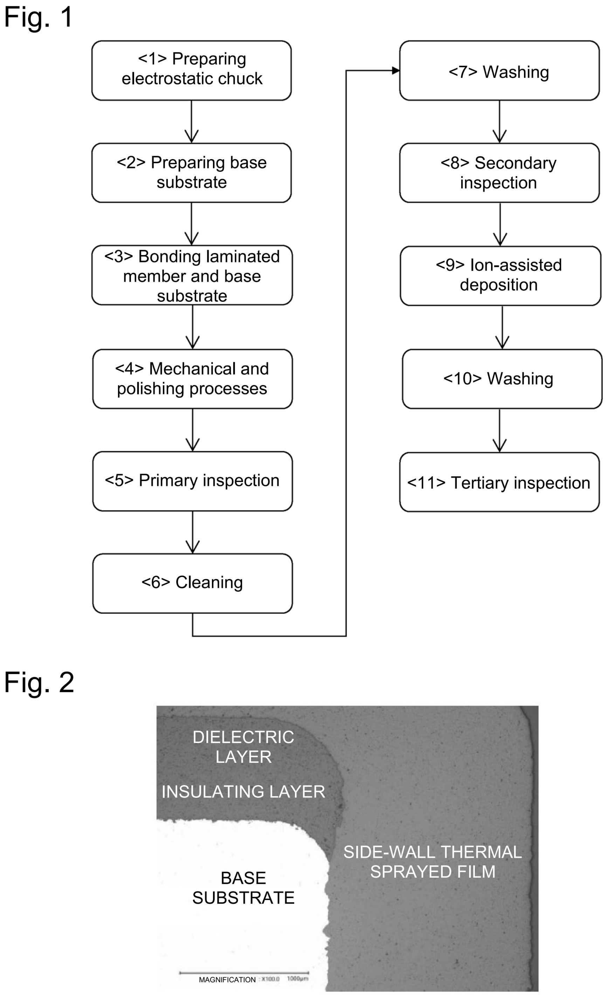

Figure 1 shows a summary of a process flowchart to obtain the electrostatic chuck device according to the present invention.

First, for <1> preparing the electrostatic chuck, prepared are ceramic green sheets having an alumina purity of 99.5% or more for forming each of a dielectric layer having a thickness of about 250 to 350 µm and an insulating layer having a thickness of about 600 to 2600 µm. An internal electrode is set to have a thickness of about 20 to 50 µm. In this case, the internal electrode can be formed by processing a metal having a high melting point, such as W and Mo, disposing a bulk member such as the same type of metal foil or mesh, printing a metal paste containing a transition metal, etc. such as Ag and Pt on the side of the dielectric layer or the side of the insulating layer, etc.

Then, so as to have an order of the dielectric layer, the internal electrode, and the insulating layer, the green sheets therefor and a material to form the internal electrode are laminated and calcined, or alternatively integrated by hot-press calcination to obtain a laminated member. This allows each of the dielectric layer and the insulating layer to become sintered Al₂O₃.

<2> Prepared as the base substrate is a member having a coolant flow path for supplying a cooling gas such as helium to the workpiece or for flowing cooling water for cooling the electrostatic chuck. This base substrate is preferably formed by using highly pure aluminum, and the used member is subjected to an alumite treatment on a laminate surface for laminating the electrostatic chuck and on a portion not protected by a side-wall thermal sprayed film, described later. Note that a screw hole for fixing the electrostatic chuck, attaching a power supplying pin for supplying power to the internal electrode of the electrostatic chuck, etc. may be the same as those in a known electrostatic chuck device.

Then, the laminated member and the base substrate prepared above are adhered by using a silicone-based adhesive for <3> bonding of these. The silicone-based adhesive used here is not particularly limited as long as it contains a resin with SiO₂ as a raw material (silicone) as a main component and is supplied as a semiconductor grade, and examples of a commercial product thereof include silicone adhesives manufactured by Dow Toray Co., Ltd. and silicone adhesives manufactured by Toray Industries, Inc. In this case, for example, the power supplying pin to be connected with the internal electrode of the electrostatic chuck may be treated similarly to a case of a known electrostatic chuck device such that the silicone-based adhesive is adhered on a contact portion thereof together with an insulative cover (an insulative sleeve). In addition, when the laminate structure is obtained by <3> bonding the laminated member and the base member, a ceramic thermal sprayed film (namely, a side-wall thermal sprayed film) composed of yttrium oxide or aluminum oxide is formed on a side surface of the laminate structure so as to cover an end surface of this bonding portion for a purpose of preventing corrosion by plasma.

After the laminated member and the base substrate, which are to constitute the electrostatic chuck, are bonded to obtain the laminate structure as above, the upper surface corresponding to the side of the dielectric layer of the laminated member in the laminate structure is <4> mechanically processed and polishing processed. In addition, the side surface of the laminated member composed of the dielectric layer, the internal electrode, and the insulating layer is <4> mechanically processed. In this case, the upper surface of the laminated member is necessarily polished so as to have surface roughness according to use process for application of the electrostatic chuck device. Meanwhile, the side surface of the laminated member is polished for a purpose of regulating an outer diameter size of the electrostatic chuck, and polishing process is performed corresponding to a size of the workpiece to be attracted.

Here, the <4> mechanically processed and polishing processed laminate structure as above is subjected to <5> primary performance inspection of measuring a volume resistivity and a leakage current value of the dielectric layer corresponding to the upper surface of the laminated member. That is, the volume resistivity at room temperature is confirmed to be 1×10¹⁵ Ω·cm or more and the leakage current value is confirmed to be 5×10⁻³ µA or less. Note that the leakage current value refers to a leakage current value between the surface of the dielectric layer corresponding to the upper surface of the laminated member and the internal electrode.

After <5> the primary performance inspection, the surface of the dielectric layer in the laminated member is <6> cleaned. This cleaning is performed with two types of treatment: a chemical treatment performed by using an organic solvent; and a physical treatment of applying ultrasonic waves to pure water for washing. In this case, the laminate structure is protected by a masking treatment so that portions other than the surface of the dielectric layer are not affected by these cleanings. After the cleaning by the chemical treatment and the cleaning by the physical treatment are performed, <7> the laminate structure is washed by using an organic solvent such as isopropyl alcohol (IPA) and by using pure water.

After <7> the washing, <8> secondary performance inspection of measuring again the volume resistivity and the leakage current value of the dielectric layer corresponding to the upper surface of the laminated member is performed to confirm the volume resistivity at room temperature to be 1×10¹⁵ Ω·cm or more and the leakage current value to be 5×10⁻³ µA or less.

Then, <9> ion-assisted deposition of forming the alumina coating film is performed by ion-assisted deposition on the surface of the dielectric layer of the laminated member in the laminate structure. In this time, a preferable condition of the ion-assisted deposition is as follows.

That is, a film-forming material in the ion-assisted deposition is Al₂O₃, a mixed gas of argon/oxygen is used as a film-forming process gas, an introduced oxygen amount is regulated within a range of 30 to 60 sccm, and an introduced argon amount is regulated within a range of 10 to 100 sccm. An acceleration voltage is 100 to 200 V, and a vacuum degree is 1×10⁻⁴ to 1×10⁻¹ Pa. The alumina coating film having a thickness of 1 µm or more and 5 µm or less formed under this film-forming condition can yield the alumina coating film having needed quality at the film-forming temperature of 100°C or less while reducing the damage. Note that portions other than the surface of the dielectric layer on which the alumina coating film are to be formed is protected by masking.

Thereafter, <10> washing is performed again by using pure water, and then performed is <11> tertiary performance inspection of measuring the volume resistivity and the leakage current value of the alumina coating film obtained above. In this <11> tertiary performance inspection, a size and plainness of the electrostatic chuck are measured, no abnormality on the alumina coating is detected, the volume resistivity at room temperature of the alumina-coated electrostatic chuck is confirmed to be 1×10¹⁵ Ω·cm or more, and the leakage current value is confirmed to be 5×10⁻³ µA or less, which complete the electrostatic chuck device according to the present invention.

The above relates to a case where the electrostatic chuck device is newly manufactured. When a used electrostatic chuck device is refurbished, procedure from <5> in the process flowchart shown in Figure 1 is performed. In this case, in <5> the primary inspection and <8> the second inspection, the volume resistivity and the leakage current value of the used electrostatic chuck as it is (in this state) are measured and confirmed, the other steps are the same as in the case of newly manufacturing the electrostatic chuck device to perform <9> the ion-assisted deposition, etc. This enables refurbishment of the used electrostatic chuck device.

### [Test Examples 1 and 2]

In accordance with the process flowchart shown in the Figure 1, an electrostatic chuck device according to Test Example 1 (Example) was manufactured. In this time, an alumina coating film having a thickness of 4 µm was formed on a surface of a dielectric layer within the following condition range in <9> the ion-assisted deposition. The film-forming temperature at this time was 100°C or less. This film-forming temperature is measured as an environment temperature of the electrostatic chuck to be film-formed.
Film-forming process gas: mixed gas of argon/oxygen Introduced oxygen amount: 20 to 40 sccm, introduced argon amount: 5 to 10 sccm
Acceleration voltage: 400 to 500 V
Vacuum degree: 1×10⁻² Pa or less

Figure 2 shows a sectional photograph (an optical microscope photograph with a magnification of 100 times) of the obtained electrostatic chuck device. According to this, no crack, etc. was generated on portions including the insulating layer, the dielectric layer, and the side-wall thermal sprayed film on the base substrate.

Meanwhile, an electrostatic chuck device according to Test Example 2 (Comparative Example) was manufactured in the same manner as in Test Example 1 except that an alumina coating film having a film thickness of 10 µm was formed under each condition of <9> the ion-assisted deposition in the Test Example 1. Note that the film-forming temperature in the <9> ion-assisted deposition in Test Example 2 reached 150°C.

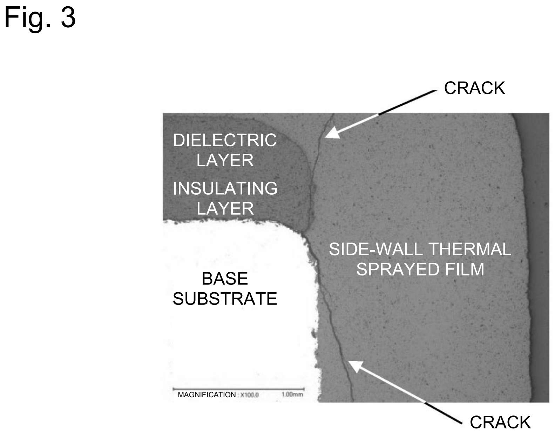

Figure 3 shows a sectional photograph of the electrostatic chuck device of Test Example 2 (Comparative Example). According to this, it was confirmed that a crack was generated at each of a position in contact with the base substrate and a position in contact with the dielectric layer/the insulating layer in the side-wall thermal sprayed film. That is, it was found that, if the film-forming conditions of the ion-assisted deposition other than the film thickness were common but the film thickness of the alumina coating film formed on the surface of the dielectric layer was too large, the damage increased and the electrostatic chuck device was adversely affected.

## Claims

1. An electrostatic chuck device, comprising:
a base substrate having a coolant flow path; and
an electrostatic chuck having an internal electrode between an insulating layer and a dielectric layer, wherein a side of the dielectric layer serves as a workpiece attraction surface,
wherein the dielectric layer of the electrostatic chuck has an alumina coating film composed of Al₂O₃ having a thickness of 1 µm or more and 5 µm or less on a surface thereof, and
the workpiece attraction surface has a volume resistivity at room temperature of 1×10¹⁵ Ω·cm or more.

2. The electrostatic chuck device according to claim 1, wherein a leakage current value of the workpiece attraction surface is 5×10⁻³ µA or less.

3. The electrostatic chuck device according to claim 1, wherein the base substrate and the electrostatic chuck are bonded via a silicone-based adhesive.

4. The electrostatic chuck device according to claim 3, comprising a ceramic thermal sprayed film so as to cover an end surface of a bonding portion where the base substrate and the electrostatic chuck are bonded.

5. The electrostatic chuck device according to claim 1, wherein the alumina coating film is formed by ion-assisted deposition.

6. A method for manufacturing an electrostatic chuck device comprising an electrostatic chuck on a base substrate having a coolant flow path, the method comprising:
providing an insulating layer, an internal electrode, and a dielectric layer on the base substrate to form a laminate structure; and
subsequently forming an alumina coating film composed of Al₂O₃ having a thickness of 1 µm or more and 5 µm or less on a surface of the dielectric layer at a film-forming temperature of 100°C or less by ion-assisted deposition to provide a workpiece attraction surface having a volume resistivity of 1×10¹⁵ Ω·cm or more on a side of the dielectric layer, thereby forming the electrostatic chuck on the base substrate.

7. The method for manufacturing an electrostatic chuck device according to claim 6, comprising:
providing the insulating layer, the internal electrode, and the dielectric layer on the base substrate via a silicone adhesive to form the laminate structure; and
subsequently forming the alumina coating film on the surface of the dielectric layer.

8. The method for manufacturing an electrostatic chuck device according to claim 7, comprising:
providing the insulating layer, the internal electrode, and the dielectric layer on the base substrate to form the laminate structure;
subsequently providing a ceramic thermal sprayed film on a side surface of the laminate structure; and
subsequently forming the alumina coating film on the surface of the dielectric layer.

9. A method of refurbishing a used electrostatic chuck device comprising a base substrate having a coolant flow path, and an electrostatic chuck having an internal electrode between an insulating layer and a dielectric layer, wherein a side of the dielectric layer serves as a workpiece attraction surface, the method comprising:
forming an alumina coating film composed of Al₂O₃ having a thickness of 1 µm or more and 5 µm or less on a surface of the dielectric layer of the used electrostatic chuck at a film-forming temperature of 100°C or less by ion-assisted deposition to provide a refurbished workpiece attraction surface having a volume resistivity of 1×10¹⁵ Ω·cm or more on the side of the dielectric layer.
